# EUROPEAN PATENT SPECIFICATION

(11) **EP 0 287 147 B1**
(45) Date of publication and mention of the grant of the patent: **04.06.1997**
(21) Application number: 88200565.5
(22) Date of filing: 25.03.1988
(51) Int. Cl.: H01L 27/082, H01L 27/088, H01L 27/02, H02P 7/00

(54) **Monolithic integrated power circuit in semibridge configuration, particularly for piloting electric motors**
Monolitisch integrierte Leistungsschaltung in Semibrückenkonfiguration, insbesondere für die Steuerung elektrischer Motoren
Circuit monolithique intégré de puissance en configuration de semi-pont, en particulier pour le contrôle de moteurs électriques

(30) Priority: 14.04.1987 IT 2011187
(43) Date of publication of application: 19.10.1988
(73) Proprietor: SGS-THOMSON MICROELECTRONICS S.r.l., 20041 Agrate Brianza (Milano) (IT)
(72) Inventor: Ferla, Giuseppe, I-95100 Catania (IT); Musumeci, Salvatore, I-95018 Riposto Catania (IT)
(74) Representative: Mittler, Enrico

(56) References cited:
- EP-A- 0 002 087
- EP-A- 0 176 762
- US-A- 4 456 920
- IBM TECHNICAL DISCLOSURE BULLETIN vol. 16, no. 2, July 1973, pages 650-651; H.H. BERGER et al.: 'Monolithically integrated logical basic circuit'
- MICROELECTRONICS AND RELIABILITY vol. 24, no. 2, 1984, Oxford, GB, pages 313-337; P. LETURCQ : 'Power bipolar devices'
- MICROELECTRONICS AND RELIABILITY vol. 16, no. 5, 1977, Oxford, GB, pages 607-616; J.O.M. JENKINS : 'MOS Power - The challenge to power bipolars'

## Description

The present invention relates to a monolithic integrated power circuit in a semibridge configuration, particularly for piloting electric motors.

To pilot alternating current electric motors starting from a continuous voltage recourse is often had to circuits in semibridge configuration, i.e. consisting of two electronic switches connected in series between two power terminals of different polarity and having a common intermediate terminal to which is connected the motor to be piloted. By appropriately piloting the two switches in such a manner that one is closed while the other is open and vice versa the motor is passed through by the current in both directions with no need to reverse the voltage supply. Naturally two semibridge circuits coupled together form a bridge circuit.

To achieve integration of a semibridge circuit it is possible to use the technology of linear integrated circuits based on the doping of appropriate areas of a silicon substrate in such a manner as to form buried layers accessible through sinkers which develop perpendicularly to the principal surface of the substrate.

This technology however involves limitations and drawbacks. The limitations are represented by an ever greater use of silicon as voltage increases. The drawbacks are represented first by a considerable dissipation of power due to the fact that the flow of current from the collector to the emitter of each switch follows a U path to and from the related buried layer, thus meeting with considerable resistances in series which increase with the thickness of the various doped layers, which in turn grow with the voltage involved. In addition the geometrical condition to be respected (three terminals on the same surface) is rather arduous.

EP-A-0002087 discloses a monolithic semiconductor device comprising two bipolar transistors connected to one another in a semibridge configuration. On a substrate having two oppositely doped adjacent portions there are formed two superimposed oppositely doped epitaxial layers. Doped areas are defined in the upper epitaxial layer. Metal contacts connected with said doped areas define power terminals of the semi bridge and a metallization extending along the substrate surface defines an intermediate terminal between the two transistors.

The object of the present invention is to provide a monolithic integrated power circuit in semibridge configuration which would overcome the limitations and drawbacks of the known art, particularly permitting low dissipation of power and a very functional use of the available silicon.

In accordance with the invention said object is achieved by a monolithic integrated power circuit in semibridge configuration as defined in claim 1.

Various solutions are available for the two switches included in the semibridge circuit. Some of them will be described in detail below purely as nonlimiting examples and with reference to the annexed drawings wherein:
FIG. 1 shows the general diagram of the concept of a semibridge used to pilot an electric motor,
FIG. 2 shows the general diagram of the bridge circuit concept formed by coupling two semibridge circuits like the one shown in FIG. 1, again for piloting an electric motor,
FIG. 3 shows the electric diagram of a possible circuital configuration for a semibridge circuit accomplishable in a monolithic integrated form in accordance with the present invention,
FIG. 4 shows the monolithic integrated structure corresponding to the circuital configuration of FIG. 3,
FIG. 5 shows the electrical diagram of another circuital configuration for a semibridge circuit accomplishable in monolithic integrated form in accordance with the present invention,
FIG. 6 shows the monolithic integrated structure corresponding to the circuital configuration of FIG. 5, and
FIGS. 7 and 8 show the electrical diagram of other circuital configurations for a semibridge circuit accomplishable in monolithic integrated form in accordance with the present invention.

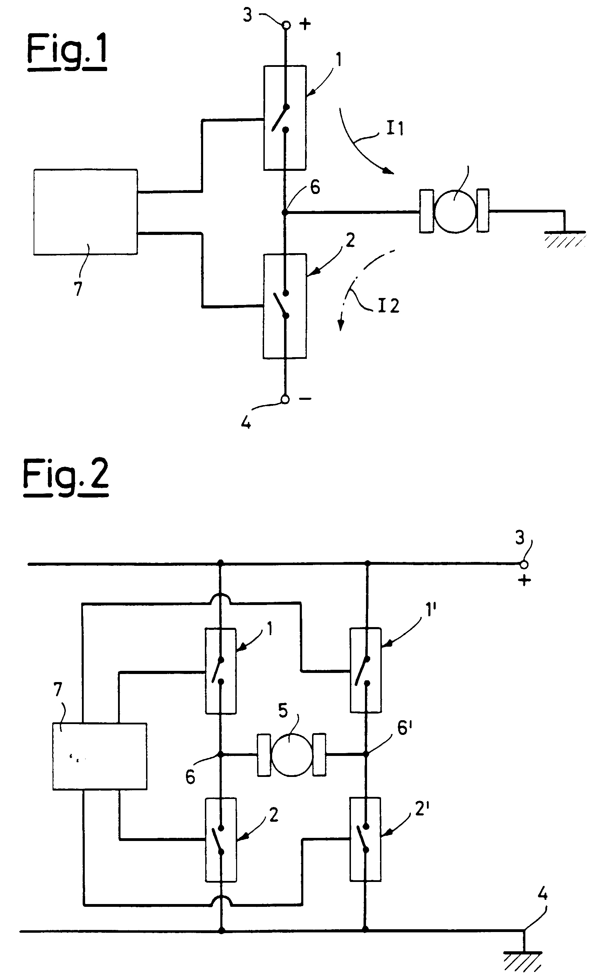

A typical semibridge pilot circuit for electric motors is shown in FIG. 1 and comprises two electronic switches 1 and 2 connected in series between a positive power terminal 3 and a negative power terminal 4. The motor to be piloted is indicated by reference number 5 and is placed between an intermediate terminal 6 formed by two switches 1 and 2 and ground. A logic circuit 7 controls the two switches 1 and 2 in such a manner that the former is closed and conducts current while the second is open and does not conduct and vice versa. In this manner the motor 5 is alternately traversed by a current I1 in one direction or by a current I2 in the opposite direction while keeping the supply voltage unchanged.

Two semibridge circuits like those shown in FIG. 1 can be coupled together to form a bridge circuit like the one shown in FIG. 2 where the second semibridge circuit is indicated by the same reference numbers with the addition of an apex.

A semibridge pilot circuit like the one shown in FIG. 1 can be accomplished in monolithic integrated form in accordance with the present invention taking care that the two switches 1 and 2 are formed in first and second laterally adjacent zones of the same silicon substrate in such a manner as to be traversed by respective parallel straight line flows in opposite directions from a top surface of the substrate, including the two power terminals 3 and 4, to the opposite bottom surface of the same substrate including the intermediate terminal 6.

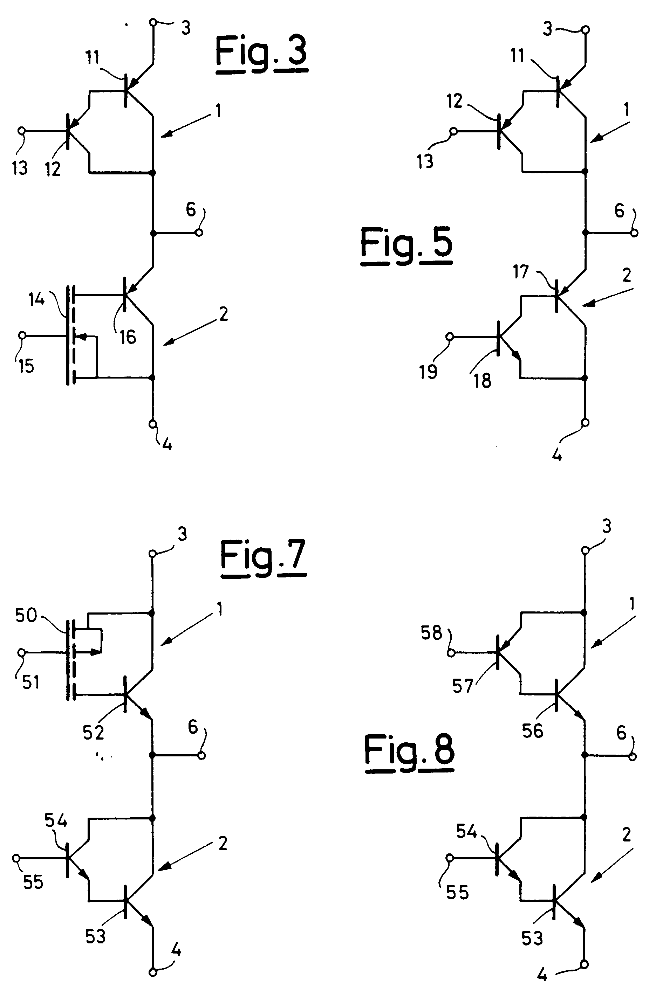

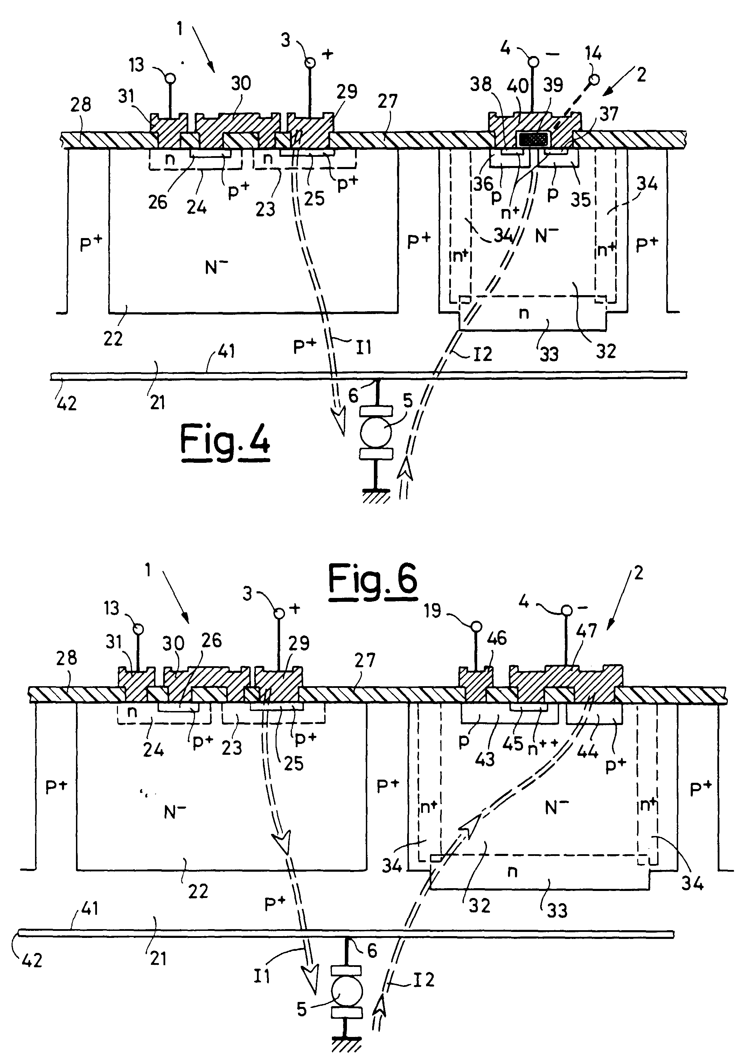

This can be achieved for various circuital configurations of the semibridge circuit. One of these is illustrated in FIG. 3 and comprises as switch 1 a PNP Darlington circuit made up of two current-piloted PNP transistors 11 and 12 in a position corresponding to that of the base terminal 13 of the transistor 12 and, as switch 2, a HIMOS, COMFET or IGT power circuit made up of a voltage-piloted N channel MOS power transistor 14 in a position corresponding to that of its gate terminal 15 and a PNP transistor 16.

In a monolithic integrated structure accomplished in accordance with the invention the circuital configuration of FIG. 3 assumes the appearance shown in FIG. 4 where the arrows I1 and I2 indicate the current flows which pass through the two switches 1 and 2.

More precisely the switch 1 is formed in a first zone of a P⁺ doped silicon substrate 21 which forms the common collector of the transistors 11 and 12 and is provided with an N⁻ epitaxial layer 22 in which have been made two N doped areas 23 and 24 forming the bases of the transistors 11 and 12, inside which have also been made two P⁺ doped areas 25 and 26 forming the emitters of the transistors 11 and 12. Said doped areas 23-24 and 25-26 are formed in a position corresponding to that of a top surface 27 of the substrate 21 on which is grown an insulating oxide layer 28 through which are passed metal contacts 29, 30 and 31. The contact 29 reaches the doped area 25 to form the power terminal 3, the contact 30 reaches the doped areas 23 and 26 to accomplish the connection between the base of the transistor 11 and the emitter of the transistor 12 and the contact 31 reaches the doped area 24 to form the pilot terminal 13.

The switch 2 is formed in a second zone of the silicon substrate 21, laterally adjacent to the first, where there is grown an N⁻ epitaxial layer 32 encircled by a lower N area 33 and by two N⁺ side areas 34. In the upper part of the epitaxial layer 32 in a position corresponding to that of the surface 27 of the substrate 21 there are made two P doped areas 35 and 36 inside which are made two N⁺ doped areas 37 and 38. A polysilicon strip 39 connected to the pilot terminal 14 and encircled by insulating oxide is associated with said doped areas 35-38, which are connected together electrically by a metal surface contact 40 which forms the power terminal 4. The P⁺ substrate 21 together with the N doped area 33 and the P doped area 35 form the PNP transistor 16 while the P doped area 36 and the N⁺ doped area 38 together with the epitaxial layer 32 and the gate polysilicon 39 form the power MOS 14.

On a bottom surface 41 of the substrate 21 opposite the top surface there is placed a metallization 42 which forms the intermediate terminal 6 to which is attached the motor 5 to be piloted.

The resulting current flows I1 and I2, alternating in accordance with commands given by the logic circuit 7, consequently have vertical straight directions in opposing directions from one surface to the other of the substrate and vice versa as shown in FIG. 4.

Another possible circuital configuration of the semibridge circuit in accordance with the invention is shown in FIG. 5 and comprises, as switch 1, a PNP Darlington circuit made up of two PNP transistors 11 and 12 current-piloted to the base terminal 13 while the switch 2 is made up of a PNP transistor 17 and an NPN transistor 18 current-piloted to the base terminal 19.

In a monolithic integrated circuit in accordance with the present invention the circuital configuration of FIG. 5 assumes the appearance shown in FIG. 6, i.e. keeps the same structure as that shown in FIG. 4 as concerns the switch 1 while for the switch 2 the N⁻ epitaxial layer 32 now calls for a P doped area 43 and a P⁺ doped area 44 in a position corresponding to that of the upper surface 27 of the substrate 21, the former of which surrounds an N⁺⁺ doped area 45. A metallic surface contact 46 reaches the P doped area 43 through the oxide area 28 to connect said P doped area 43 with the pilot terminal 19 and another metallic surface contact 47 reaches the N⁺⁺ doped area and the P⁺ doped area through the oxide layer 28 to connect said doped areas together and with the negative power terminal 4. The substrate 21, the N doped area 33 and the P⁺ doped area 44 form the PNP transistor 17 while the P doped area 43, the N⁺⁺ doped area 45 and the N doped area 33 form the NPN transistor 18.

Other possible circuital configurations of the semibridge circuit in accordance with the invention are illustrated in FIGS. 7 and 8. More specifically, the circuit shown in FIG. 7 comprises as switch 1 a HIMOS or COMFET or IGT circuit made up of a P channel power MOS voltage-piloted to the gate terminal 51 and an NPN transistor 52 and, as switch 2, an NPN Darlington circuit made up of two NPN transistors 53 and 54, the latter current-piloted to the gate terminal 55. The circuit shown in FIG. 8 comprises as switch 1, an NPN transistor 56 and a PNP transistor 57 current-piloted to the gate terminal 58 and, as switch 2, an NPN Darlington circuit exactly the same as that shown in FIG. 7.

The integrated version is the same as those shown in FIGS. 4 and 6 with the only precaution of exchanging the P areas with the N areas and vice versa. In addition the two voltage feeds at the terminals 3 and 4 are reversed.

## Claims

1. Monolithic integrated power circuit in a semibridge configuration including a first and a second electronic switch (1, 2) connected in series and formed in respective first and second laterally adjacent zones of a single silicon substrate (21) of a first conductivity type to provide respective first and second straight current flows in opposite directions from a first power terminal (3) formed by a first metallic contact (29) at a top surface (27) of the monolithic integrated semiconductor structure to an intermediate terminal (6) formed by a metallization (42) at an opposite bottom surface (41) of the substrate and from said intermediate terminal (6) to a second power terminal (4) formed by a second metallic contact (40; 47) at said top surface (27), wherein said first switch (1) comprises two transistors defined by said first zone, a first epitaxial layer (22) of a second opposite conductivity type formed on the first zone and extending to the top surface (27) and doped areas (23-26) provided in said first epitaxial layer, at least one doped area (25) being electrically connected to said first metallic contact (29), and said second switch (2) comprises two transistors defined by said second zone, a second epitaxial layer (32) of a second opposite conductivity type formed on the second zone and extending to the top surface (27) and doped areas (35-38; 43-45) provided in said second epitaxial layer, at least one doped area (35-38) being electrically connected to said second metallic contact (40; 47), wherein said second epitaxial layer is laterally separated from said first epitaxial layer by a portion of said substrate.

2. Monolithic integrated circuit in accordance with claim 1 characterized in that said first switch (1) consists of a Darlington circuit formed of two PNP transistors (11, 12).

3. Monolithic integrated circuit in accordance with claim 2 characterized in that said transistors (11, 12) are formed in a P⁺ doped silicon substrate (21) on which is grown an N⁻ epitaxial layer (22) in which are formed, in a position corresponding to that of said top surface (27) of the substrate, two adjacent N doped areas (23, 24) enclosing respective P⁺ doped areas, there being provided on said top surface (27) a metallic contact (29) connected to said P⁺ doped area (25) and forming a positive power terminal (3), a metallic contact (30) for electrical connection of one (23) of said N doped areas (23, 24) with one (26) of said P⁺ doped areas (25, 26) and a metallic contact (31) connected to said N doped area (24) and forming a pilot terminal (13).

4. Monolithic integrated circuit in accordance with claim 2 characterized in that said second switch (2) consists of a HIMOS power circuit formed of an N channel MOS power transistor (14) and a PNP transistor (16) piloted by said MOS power transistor (14).

5. Monolithic integrated circuit in accordance with claim 4 characterized in that said HIMOS power circuit is formed in a P⁺ doped silicon substrate (21) on which is grown an N⁻ epitaxial layer (32) separated from the substrate (21) by an N doped area (33), there being made in said epitaxial layer (32), in a position corresponding to that of said top surface (27) of the substrate, two adjacent P doped areas (35, 36) enclosing respective N⁺ doped areas, and there being provided on said top surface (27) a polysilicon strip (39) interacting with said doped areas (35-38), there being also provided on said top surface (27) a metallic contact (40) which connects said P and N⁻ doped areas (35-38) and forms a negative power terminal (4), and means for electrical connection of said polysilicon strip (39) to a pilot terminal (15).

6. Monolithic integrated circuit in accordance with claim 2 characterized in that said second switch (2) consists of an NPN transistor (18) and a PNP transistor (17) piloted by said NPN transitor (18).

7. Monolithic integrated circuit in accordance with claim 6 characterized in that said NPN transistor (18) and said PNP transistor (17) are formed in a P⁺ doped silicon substrate (21) on which is grown an N⁻ epitaxial layer (32) separated from the substrate (21) by an N doped area (33), there being made in said epitaxial layer (32) in a position corresponding to that of said top surface of the substrate a P⁺ doped area (44) and an adjacent P doped area (43) enclosing an N⁺⁺ doped area (45), there being provided on said top surface (27) a metallic contact (46) connected to said P doped area (43) and forming a pilot terminal (19) and another metallic contact (47) which connects said P⁺ doped area (44) and said N⁺⁺ doped area (45) and forms a negative power terminal (4).

8. Monolithic integrated circuit in accordance with claim 1 characterized in that said second switch (2) is made up of a Darlington circuit formed of two NPN transistors (53, 54).

9. Monolithic integrated circuit in accordance with claim 8 characterized in that said first switch (1) consists of a HIMOS power circuit formed of a P channel MOS power transistor (50) and an NPN transistor (52) piloted by said power MOS (50).

10. Monolithic integrated circuit in accordance with claim 8 characterized in that said first switch (1) consists of a PNP transistor (57) and an NPN transistor (56) piloted by said NPN transistor (56).

## Patentansprüche

1. Monolithische integrierte Leistungschaltung in einer Semibrückenkonfiguration
mit einem ersten und einem zweiten elektronischen Schalter (1, 2), die in Reihe geschaltet sind und in einer entsprechenden ersten und zweiten seitlich benachbarten Zone eines enizelnen Siliziumsubstrates (21) eines ersten Leitungstypes gebildet sind zum Vorsehen eines entsprechenden ersten und zweiten geraden Stromflusses in entgegengesetzte Richtungen von einem ersten Leistungsanschluß (3), der durch einen ersten metallischen Kontakt (29) auf einer oberen Oberfläche (27) des monolithischen integrierten Halbleiteraufbaus gebildet ist,
zu einem mittleren Anschluß (6), der durch eine Metallisierung (42) an einer gegenüberliegenden Bodenoberfläche (41) des Substrates gebildet ist, und von dem mittleren Anschluß (6) zu einem zweiten Leistungsanschluß (4), der durch einen zweiten metallischen Kontakt (40; 47) an der oberen Oberfläche (27) gebildet ist,
wobei der erste Schalter (1) zwei durch die erste Zone definierte Transistoren, eine erste epitaxiale Schicht (22) eines zweiten entgegengesetzten Leitungstypes, die auf der ersten Zone gebildet ist und sich zu der oberen Oberfläche (27) erstreckt, und dotierte Bereiche (23 - 26), die in der ersten epitaxialen Schicht vorgesehen sind, aufweist und mindestens ein dotierter Bereich (25) elektrisch mit dem ersten metallischen Kontakt (29) verbunden ist,
wobei der zweite Schalter (2) zwei durch die zweite Zone definierte Transistoren, eine zweite epitaxiale Schicht (32) eines zweiten entgegengesetzten Leitungstypes, die auf der zweiten Zone gebildet ist und sich zu der oberen Oberfläche (27) erstreckt, und dotierte Bereiche (35 - 38, 43 - 45), die in der zweiten epitaxialen Schicht vorgesehen sind, aufweist, und mindestens ein dotierter Bereich (35 - 38) elektrisch mit dem zweiten metallischen Kontakt (40; 47) verbunden ist, und
wobei die zweite epitaxiale Schicht seitlich von der ersten epitaxialen Schicht durch einen Abschnitt des Substrates getrennt ist.

2. Monolithische integrierte Schaltung nach Anspruch 1,
dadurch gekennzeichnet, daß der erste Schalter (1) aus einer Darlington-Schaltung besteht, die aus zwei PNP-Transistoren (11, 12) gebildet ist.

3. Monolithische integrierte Schaltung nach Anspruch 2,
dadurch gekennzeichnet, daß die Transistoren (11, 12) in einem P⁺-dotierten Siliziumsubstrat (21) gebildet sind, auf dem eine epitaxiale N⁻-Schicht (22) aufgewachsen ist, in der an einer Position entsprechend zu der der oberen Oberfläche (27) des Substrates zwei benachbarte N-dotierte Bereiche (23, 24) gebildet sind, die entsprechende P⁺-dotierte Bereiche einschließen,
wobei auf der oberen Oberfläche (27) ein metallischer Kontakt (29), der mit dem P⁺-dotierten Bereich (25) verbunden ist und einen positiven Leistungsanschluß (3) bildet,
ein metallischer Kontakt (30) für eine elektrische Verbindung von einem (23) der N-dotierten Bereiche (23, 24) mit einem (26) der P⁺-dotierten Bereiche (25, 26) und ein metallischer Kontakt (31), der mit dem N-dotierten Bereich (24) verbunden ist und einen Steueranschluß (13) bildet, vorgesehen sind.

4. Monolithische integrierte Schaltung nach Anspruch 2,
dadurch gekennzeichnet, daß der zweite Schalter (2) aus einer HIMOS-Leistungsschaltung besteht, die aus einem N-Kanal-MOS-Leistungstransistor (14) und einem PNP-Transistor (16), der durch den MOS-Leistungstransistor (14) gesteuert wird, gebildet ist.

5. Monolithische integrierte Schaltung nach Anspruch 4,
dadurch gekennzeichnet, daß die HIMOS-Leistungsschaltung in einem P⁺-dotierten Siliziumsubstrat (21) gebildet ist, auf der eine epitaxiale N⁻-Schicht (32) aufgewachsen ist, die von dem Substrat (21) durch einen N-dotierten Bereich (33) getrennt ist,
wobei in der epitaxialen Schicht (32) an einer Position, die der oberen Oberfläche (27) des Substrates entspricht, zwei benachbarte P-dotierte Bereiche (35, 36) gemacht sind, die entsprechende N⁺-dotierte Bereiche einschließen, und
wobei auf der oberen Oberfläche (27) ein Polisiliziumstreifen (39) vorgesehen ist, der mit den dotierten Bereichen (35 - 38) wechselwirkt,
wobei ebenfalls auf der oberen Oberfläche (27) ein metallischer Kontakt (40) vorgesehen ist, der die P- und N⁺-dotierten Bereiche (35 - 38) verbindet und einen negativen Leistungsanschluß (4) bildet, und Mittel vorgesehen sind zum elektrischen Verbinden des Polisiliziumstreifens (39) mit einem Steueranschluß (15).

6. Monolithische integrierte Schaltung nach Anspruch 2,
dadurch gekennzeichnet, daß der zweite Schalter (2) aus einem NPN-Transistor (18) und einem PNP-Transistor (17), der durch den NPN-Transistor (18) gesteuert wird, besteht.

7. Monolithische integrierte Schaltung nach Anspruch 6,
dadurch gekennzeichnet, daß der NPN-Transistor (18) und der PNP-Transistor (17) in einem P⁺-dotierten Siliziumsubstrat (21) gebildet sind, auf dem eine epitaxiale N⁻-Schicht (32) aufgewachsen ist, die von dem Substrat (21) durch einen N-dotierten Bereich (33) getrennt ist,
wobei in der epitaxialen Schicht (32) an einer Position entsprechend der der oberen Oberfläche des Substrates ein P⁺-dotierter Bereich (44) und ein benachbarter P-dotierter Bereich (43) gemacht sind, die einen N⁺⁺-dotierten Bereich (45) einschließen,
wobei auf der oberen Oberfläche (27) ein metallischer Kontakt (46), der mit dem P-dotierten Bereich (43) verbunden ist und einen Steueranschluß (19) bildet, und ein anderer metallischer Kontakt (47), der den P⁺-dotierten Bereich (44) mit dem N⁺⁺-dotierten Bereich (45) verbindet und einen negativen Leistungsanschluß (4) bildet, vorgesehen sind.

8. Monolithische integrierte Schaltung nach Anspruch 1,
dadurch gekennzeichnet, daß der zweite Schalter (2) aus einer Darlington-Schaltung gemacht ist, die aus zwei NPN-Transistoren (53, 54) gebildet ist.

9. Monolithische integrierte Schaltung nach Anspruch 8,
dadurch gekennzeichnet, daß der erste Schalter (1) aus einer HIMOS-Leistungsschaltung besteht, die aus einem P-Kanal-MOS-Leistungstransistor (50) und einem NPN-Transistor (52), der durch den Leistungs-MOS (50) gesteuert wird, gebildet ist.

10. Monolithische integrierte Schaltung nach Anspruch 8,
dadurch gekennzeichnet, daß der erste Schalter (1) aus einem PNP-Transistor (57) und einem NPN-Transistor (56), der durch den PNP-Transistor (57) gesteuert wird, besteht.

## Revendications

1. Circuit de puissance intégré monolithique en configuration en demi-pont comprenant des premier et second commutateurs électroniques (1, 2) connectés en série et formés dans des première et seconde zones respectives adjacentes latéralement d'un substrat de silicium monocristallin (21) d'un premier type de conductivité pour fournir des première et seconde circulations de courant rectilignes dans des directions opposées, à partir d'une première borne de puissance (3) formée par un premier contact métallique (29) sur une surface supérieure (27) de la structure semiconductrice intégrée monolithique vers une borne intermédiaire (6) constituée d'une métallisation (42) sur une surface inférieure opposée (41) du substrat et à partir de la borne intermédiaire (6) vers une seconde borne de puissance (4) formée d'un second contact métallique (40, 47) sur ladite surface supérieure (27), dans lequel le premier commutateur (1) comprend deux transistors formés dans la première zone, une première couche épitaxiale (22) d'un second type de conductivité opposé formée sur la première zone et s'étendant sur la surface supérieure (27) et des zones dopées (23, 26) formées dans la première couche épitaxiale, au moins une zone dopée (25) étant électriquement connectée au premier contact métallique (29) et dans lequel le second commutateur (2) comprend deux transistors formés dans la seconde zone, une seconde couche épitaxiale (32) d'un second type de conductivité opposé formé sur la seconde zone et s'étendant vers la surface supérieure (27) et des zones dopées (35-38 ; 43-45) prévues dans la seconde couche épitaxiale, au moins une zone dopée (35-38) étant électriquement connectée au second contact métallique (40 ; 47), dans lequel la seconde couche épitaxiale est séparée latéralement de la première couche épitaxiale par une partie dudit substrat.

2. Circuit intégré monolithique selon la revendication 1, caractérisé en ce que le premier commutateur (1) consiste en un circuit Darlington constitué de deux transistors PNP (11, 12).

3. Circuit intégré monolithique selon la revendication 2, caractérisé en ce que les transistors (11, 12) sont formés dans un substrat de silicium (21) dopé P⁺ sur lequel est amenée à croître une couche épitaxiale N⁻ (22) dans laquelle sont formées, à une position qui correspond à celle de la surface supérieure (27) du substrat, deux zones dopées N adjacentes (23, 24) enfermant des zones dopées P⁺ respectives, la surface supérieure (27) supportant un contact métallique (29) connecté à la zone dopée P⁺ (25) et formant une borne de puissance positive (3), un contact métallique (30) pour une connexion électrique de l'une (23) des zones dopées N (23, 24) avec l'une (26) des zones dopées P⁺ (25, 26), et un contact métallique (31) connecté à la zone dopée N (24) et formant une borne pilote (13).

4. Circuit intégré monolithique selon la revendication 2, caractérisé en ce que le second commutateur (2) comprend un circuit de puissance HIMOS constitué d'un transistor MOS de puissance à canal N (14) et d'un transistor PNP (16) piloté par le transistor MOS de puissance (14).

5. Circuit intégré monolithique selon la revendication 4, caractérisé en ce que le circuit de puissance HIMOS est formé dans un substrat de silicium dopé P⁺ (21) sur lequel est amenée à croître une couche épitaxiale N⁻ (32) séparée du substrat (21) par une zone dopée N (33), la couche épitaxiale (32) comportant, à une position correspondant à celle de la surface supérieure (27) du substrat, deux zones adjacentes dopées P (35, 36) contenant des zones dopées N⁺ respectives, et, sur la surface supérieure (27), une bande de silicium polycristallin (39) interagissant avec les zones dopées (35, 38), et également un contact métallique (40) qui connecte les zones dopées P et N⁺ (35-38) et forme une borne d'alimentation négative (4), et des moyens de connexion électrique de la bande de silicium polycristallin (39) à une borne pilote (15).

6. Circuit intégré monolithique selon la revendication 2, caractérisé en ce que le second commutateur (2) consiste en un transistor NPN (18) et un transistor PNP (17) piloté par le transistor NPN (18).

7. Circuit intégré monolithique selon la revendication 6, caractérisé en ce que le transistor NPN (18) et le transistor PNP (17) sont formés dans un substrat de silicium dopé P⁺ (21) sur lequel est amené à croître une couche épitaxiale N⁻ (32) séparée du substrat (21) par une zone dopée N (33), la couche épitaxiale (32) comportant, à une position qui correspond à celle de ladite surface supérieure du substrat, une zone dopée P⁺ (44) et une zone dopée P adjacente (43) entourant une zone dopée N⁺⁺ (45), sur ladite surface supérieure (27) supportant un contact métallique (46) connecté à la zone dopée P (43) et formant une borne pilote (19) et un autre contact métallique (47) qui relie la zone dopée P⁺ (44) et ladite zone dopée N⁺⁺ (45) et forme une borne de puissance négative (4).

8. Circuit intégré monolithique selon la revendication 1, caractérisé en ce que le second commutateur (2) est constitué d'un circuit Darlington formé de deux transistors NPN (53, 54).

9. Circuit intégré monolithique selon la revendication 8, caractérisé en ce que le premier commutateur (1) consiste en un circuit de puissance HIMOS formé d'un transistor MOS de puissance à canal P (50) et d'un transistor NPN (52) piloté par le MOS de puissance (50).

10. Circuit intégré monolithique selon la revendication 8, caractérisé en ce que le premier commutateur (1) consiste en un transistor PNP (57) et un transistor NPN (56) piloté par le transistor PNP (57).
